# EUROPÄISCHE PATENTSCHRIFT

(11) **EP 1 530 824 B1**
(45) Veröffentlichungstag und Bekanntmachung des Hinweises auf die Patenterteilung: **14.05.2008**
(21) Anmeldenummer: 03790662.5
(22) Anmeldetag: 30.07.2003
(51) Int. Cl.: H03M 7/40, H04N 7/30, H04N 7/26, H03M 7/46

(54) **SKALIERBARE CODIERUNG VON BILDINFORMATION, INSBESONDERE VIDEOBILDINFORMATION**
SCALABLE CODING OF IMAGE INFORMATION, ESPECIALLY VIDEO IMAGE INFORMATION
CODAGE ECHELONNABLE D'INFORMATION IMAGE, EN PARTICULIER D'INFORMATION IMAGE VIDEO

(30) Priorität: 21.08.2002 DE 10238289
(43) Veröffentlichungstag der Anmeldung: 18.05.2005
(73) Patentinhaber: SIEMENS AKTIENGESELLSCHAFT, 80333 München (DE)
(72) Erfinder: KUTKA, Robert, 82269 Geltendorf (DE)
(86) Internationale Anmeldenummer: PCT/DE2003/002565
(87) Internationale Veröffentlichungsnummer: WO 2004/021577

(56) Entgegenhaltungen:
- EP-A- 1 150 434
- US-A- 5 471 594
- LI W: "OVERVIEW OF FINE GRANULARITY SCALABILITY IN MPEG-4 VIDEO STANDARD" IEEE TRANSACTIONS ON CIRCUITS AND SYSTEMS FOR VIDEO TECHNOLOGY, IEEE INC. NEW YORK, US, Bd. 11, Nr. 3, März 2001 (2001-03), Seiten 301-317, XP000994715 ISSN: 1051-8215

## Beschreibung

Die Erfindung betrifft ein Verfahren zur skalierbaren Codierung von Bildinformation, insbesondere Videobildinformation. Ferner betrifft die Erfindung eine Codiereinheit, eine Decodiereinheit sowie eine Anordnung zur Codierung und Decodierung von Bildinformation.

In immer mehr Anwendungen ist es erforderlich, codierte Videosequenzen so aufzubereiten, dass diese mit Geräten sehr unterschiedlicher Leistungsfähigkeit decodiert werden können. Beispielsweise sollen Bildsequenzen, die eigentlich für Desktop-Applikationen codiert wurden, auch auf mobilen Endgeräten wiedergebbar sein. Auch Videokonferenzen zwischen Teilnehmern mit Desktop und mobilen Endgeräten erfordern eine Anpassung an die Übertragungsleistung. Aus technischer Sicht muss somit eine schnelle Adaption der generierten bzw. übertragenen Bitrate an sehr unterschiedliche Übertragungsbandbreiten (zum Beispiel Übertragung im Festnetz im Gegensatz zu drahtloser Übertragung) ermöglicht werden. Ein zunehmend an Bedeutung gewinnender Anwendungsfall stellen sogenannte Streaming-Applikationen dar. Hierbei stellt ein Service-Provider Videomaterial zum Abruf bereit. Der Client fordert die komprimierten Videodaten an, während gleichzeitig das decodierte Bildmaterial dargestellt wird. Auch hierbei muss der Provider sehr unterschiedlichen Kundenanforderungen Rechnung tragen.

Prinzipiell erfordern die oben beschriebenen Problemstelllungen skalierbare Codierverfahren. Bei diesen Verfahren wird senderseitig nur ein einziger Bitstrom generiert, aus dem aber Bildsequenzen geringerer Qualität und/oder Auflösung decodiert werden können. Damit kann der Empfänger für Streaming-Applikationen entscheiden, welche Auflösungsqualität er empfangen möchte. Im Bereich mobiler Applikationen mit zeitlich stark schwankenden Kanaleigenschaften ergibt sich die Möglichkeit einer sehr schnellen Adaption des Senders.

Bei dem aus EP 1 150 434 A1 bekannten Verfahren wird ein variables längencodiertes Codewort dadurch komprimiert, dass ein Codewort der Codewortfolge der variablen längencodierten Codewörter durch ein anderes Codewort ersetzt wird, wobei dieses andere Codewort kürzer ist und einen ähnlichen Wert aufweist als das eine variable längencodierte Codewort.

Bei den aus dem Stand der Technik bekannten skalierbaren Codierverfahren (siehe beispielsweise [1] und [2]) wird das zu codierende Signal mehreren sogenannten Layern zugeführt, wobei jeder Layer einer bestimmten Qualitätsstufe der Codierung entspricht. In jedem Layer wird entsprechend der gewählten Qualitätsstufe eine Entropiecodierung durchgeführt. Durch die Möglichkeit der Verwendung von verschiedenen Qualitätsstufen wird somit eine Skalierung des codierten Videosignals in Abhängigkeit von der erwünschten Bildqualität ermöglicht. Es kann hierbei zwischen örtlicher, zeitlicher und Amplituden-Skalierung unterschieden werden. Bei der örtlichen Skalierung ist jedem Layer eine unterschiedliche Bildpunktzahl und bei der zeitlichen Skalierung eine unterschiedliche Bildfolgefrequenz zugeordnet. Im Unterschied dazu wird bei der Amplituden-Skalierung, die auch als SNR-Skalierung (SNR = Signal to Noise Ratio) bezeichnet wird, die Quantisierung bzw. Bildschärfe der durch eine Transfor-mationscodierung erhaltenen Transformationskoeffizienten variiert.

Bei den bekannten Verfahren zur skalierbaren Bildcodierung erweist es sich als nachteilhaft, dass die zu codierenden Werte im jedem Layer einem eigenen Entropiecoder zugeführt werden müssen. Hierdurch wird die Codierung ineffektiv, da codierte Daten für jeden Layer übertragen werden müssen und somit eine hohe Datenrate erforderlich ist.

Aufgabe der Erfindung ist es deshalb, ein Verfahren zur skalierbaren Codierung von Bildinformation zu schaffen, bei welchem die Datenrate der zu übertragenden codierten Daten gering ist und somit eine effiziente Codierung gewährleistet ist.

Diese Aufgabe wird gemäß den Merkmalen der unabhängigen Patentansprüche gelöst. Weiterbildungen der Erfindung ergeben sich auch aus den abhängigen Ansprüchen.

Bei dem erfindungsgemäßen Verfahren, welches insbesondere zur skalierbaren Codierung von Videobildinformation eingesetzt werden kann, wird in einem ersten Codierschritt, der eine Entropiecodierung umfasst, ein Eingangssignal mit der Bildinformation in ein erstes codiertes Signal mit einer Mehrzahl von Codewörter umgewandelt, wobei jedem Codewort ein decodierter Wert zugeordnet ist. In einem darauffolgenden zweiten Codierschritt wird das erste codierte Signal dann in ein zweites codiertes Signal umgewandelt, wobei hierbei das erste codierte Signal in Abhängigkeit von einer erwünschten Datenrate für die Übertragung der Bildinformation komprimiert wird. Im Unterschied zu den Verfahren nach dem Stand der Technik wird die Bildinformation nur ein einziges Mal einer Entropiecodierung zugeführt. Die Skalierung wird nicht mehr im Entropiecodierschritt bewirkt, sondern in einem darauffolgenden Codierschritt, bei dem das durch die Entropiecodierung codierte Signal in Abhängigkeit von der erwünschten Datenrate für die Bildübertragung komprimiert wird. Der Vorteil dieses Verfahrens liegt in der effizienten Codierung, da nicht mehr eine Vielzahl von in unterschiedlichen Layern codierten Daten übertragen werden müssen. Ferner ist das Verfahren weniger komplex als die Verfahren nach dem Stand der Technik, da der erste Codierschritt nur ein einziges Mal für ein Eingangssignal durchgeführt wird.

Ferner wird durch die Erfindung die Kompression des ersten codierten Signals in dem zweiten Codierschritt dadurch bewirkt, dass die Codewörter des ersten codierten Signals verkürzt werden und jedem gekürzten Codewort ein Repräsentant zugeordnet wird. Hierdurch erfolgt eine effektive Anpassung der Skalierung an die erwünschte Datenrate, da ein einzelner Codewort entsprechend der einzuhaltenden Datenrate beliebig abgeschnitten werden kann. Um eine gute Qualität des zu übertragenden Bildes zu gewährleisten, kann der Repräsentant derart gewählt werden, dass im Mittel die beste Bildqualität für die Bildinformation erreicht wird. Um sicherzustellen, dass das übertragene Bild eine gute Übereinstimmung mit dem ursprünglichen Bild aufweist, werden bei der Erfindung einem gekürzten Codewort die durch die Verkürzung des Codeworts entfallenden ungekürzten Codewörter zugeordnet und als Repräsentant der Erwartungswert der decodierten Werte der zugeordneten ungekürzten Codewörter verwendet.

Als Kriterium für die Verkürzung der Codewörter kann in einer weiteren Ausführungsform der Erfindung neben der erwünschten Datenrate auch der decodierte Wert eines ungekürzten Codeworts herangezogen werden. Da dieser Wert Aufschluss über die Relevanz dieses Codeworts für das übertragene Bild gibt, kann eine weitere Komprimierung ohne Qualitätsverlust dadurch gewährleistet werden, dass weniger relevante Codewörter stärker verkürzt werden als Codewörter von größerer Relevanz. Die Länge, um die ein ungekürztes Codewort verkürzt wird, kann ferner von der Position des ungekürzten Codeworts im codierten Signal abhängig gemacht werden, denn diese Position ist auch ein Indikator für die Relevanz des Codeworts in dem Bild.

In einer vorteilhaften Ausführungsform der Erfindung werden die Codewörter des ersten codierten Signals in einer Matrix gespeichert, die eine Mehrzahl von Schichten umfasst, wobei jede Schicht einen Abschnitt von wenigstens einem Codewort beinhaltet. Dieser Abschnitt kann ein einzelnes Bit oder ein Bitbündel sein. Die Codewörter werden dabei vorzugsweise schichtweise ausgelesen, wobei die Anzahl der ausgelesenen Schichten von der erwünschten Datenrate abhängt. Durch eine solche schichtweise Anordnung der Codewörter kann die Datenrate für das zu übertragende Bild auf einfache Weise gesteuert werden. Darüber hinaus kann durch Veränderung der Anzahl der gespeicherten Bits pro Schicht für jedes Codewort individuell die Datenkompression festgelegt werden. Folglich können Codewörter mit größerer Relevanz weniger komprimiert werden, das heißt es werden in diesem Fall pro Schicht mehr Bits übertragen. Um die Codiereffizienz weiter zu steigern, können die Schichten in der Matrix auch noch einer Lauflängencodierung unterzogen werden.

In einer bevorzugten Ausführungsform ist die Entropiecodierung des ersten Codierschritts eine VLC-Codierung (Variable Length Coding). Ferner kann die Entropiecodierung zusätzlich noch eine RLC-Codierung (Run Level Coding) umfassen. Die VLC- und die RLC-Codierung sind hinlänglich aus dem Stand der Technik bekannte Codierverfahren (siehe beispielsweise in [2]).

In einer weiteren besonders bevorzugten Ausführungsform wird im ersten Codierschritt eine Transformationscodierung, vorzugsweise eine DCT-Transformationscodierung (Discrete Cosine Transform) durchgeführt. Um die Fehlerfortpflanzung zu minimieren, werden vorzugsweise die Codewörter des ersten codierten Signals für Intra-Bilder in geringerem Maße komprimiert als für prädizierte P-Bilder. Die Transformationscodierung ist ein bekanntes Codierverfahren und beispielsweise in [3] beschrieben.

Neben einem Codierverfahren umfasst die Erfindung auch ein Decodierverfahren zur Decodierung eines codierten Signals, bei dem ein mit dem erfindungsgemäßen Codierverfahren erzeugtes zweites codiertes Signal decodiert wird. Zur Durchführung der Decodierung wird dabei jedem Codewort des zweiten codierten Signals ein Codewort des ersten codierten Signals zugeordnet, wobei wenigstens einem gekürzten Codewort die durch die Verkürzung des Codeworts entfallenen ungekürzten Codewörter zugeordnet werden und ein Repräsentant des gekürzten Codeworts der Erwartungswert der decodierten Werte der dem gekürzten Codewort zugeordneten ungekürzten Codewörter ist.

Neben dem oben beschriebenen erfindungsgemäßen Codierverfahren umfasst die Erfindung ferner eine Codiereinheit mit der das erfindungsgemäße Codierverfahren durchführbar ist, mit einem ersten Mittel zum Umwandeln eines Eingangssignals mit der Bildinformation in einem ersten Codierschritt umfassend eine Entropiecodierung in ein erstes codiertes Signal mit einer Mehrzahl von Codewörter, wobei jedem Codewort ein decodierter Wert zugeordnet ist, einem zweiten Mittel zum Umwandeln des ersten codierten Signals in einem zweiten Codierschritt, bei dem das erste codierte Signal in Abhängigkeit von einer erwünschten Datenrate für die Übertragung der Bildinformation komprimiert wird, in ein zweites codiertes Signal, einem dritten Mittel zum Verkürzen der Codewörter des ersten codierten Signals in dem zweiten Codierschritt und zum Zuordnen eines Repräsentant jedem gekürzten Codewort, einem vierten Mittel zum Zuordnen wenigstens einem gekürzten Codewort die durch die Verkürzung des Codeworts entfallenen ungekürzten Codewörter, wobei der Repräsentant des gekürzten Codeworts der Erwartungswert der decodierten Werte der dem gekürzten Codewort zugeordneten ungekürzten Codewörter ist.

Des Weiteren umfasst die Erfindung eine Decodiereinheit, mit der das erfindungsgemäße Decodierverfahren durchführbar ist, mit einem fünften Mittel zum Decodieren eines nach einem Verfahren der vorhergehenden Ansprüche erzeugten zweiten codierten Signals, wobei jedem Codewort des zweiten codierten Signals ein Codewort des ersten codierten Signals zugeordnet wird, einem sechsten Mittel zum Zuordnen wenigstens einem gekürzten Codewort (V1, V2, V3; V1', V2', V3', V4') die durch die Verkürzung des Codeworts entfallenen ungekürzten Codewörter (C1,...,CN), wobei ein Repräsentant (R1, R2, R3; R1', R2', R3', R4') des gekürzten Codeworts der Erwartungswert (E1, E2, E3; E1', E2', E3', E4') der decodierten Werte der dem gekürzten Codewort zugeordneten ungekürzten Codewörter (C1,...,CN) ist..

Darüber hinaus betrifft die Erfindung eine Anordnung zur Codierung und Decodierung von Bildinformation, welche ein Gesamtsystem bestehend aus einer erfindungsgemäßen Codiereinheit und Decodiereinheit ist.

Ausführungsbeispiele der Erfindung werden nachfolgend anhand der Zeichnungen dargestellt und erläutert.

Es zeigen:
- Fig.1: eine schematische Darstellung des Ablaufs des erfindungsgemäßen Verfahrens;
- Fig.2: einen Baum aus VLC-Codewörter einer codierten Bildinformation, wobei die Codewörter durch den VLC- Codierschritt der Fig. 1 erhalten wurden;
- Fig. 3A und Fig.3B: Skizzen, welche die Verkürzung der VLC- Codewörter der Fig. 2 gemäß einer ersten Variante des erfindungsgemäßen Verfahrens zeigen;
- Fig.4: die Anordnung der VLC-Codewörter in einer Matrix zur Durchführung der ersten Variante des erfindungsgemäßen Verfahrens;
- Fig.5A und 5B: Skizzen zur Erläuterung der Verkürzung der VLC- Codewörter gemäß einer zweiten Variante der Erfindung;
- Fig.6: die Anordnung der VLC-Codewörter in einer Matrix zur Durchführung der zweiten Variante des erfindungsgemäßen Verfahrens;
- Fig.7: ein Diagramm, welches die Signal-zu-Rausch-Verhältnisse von Bildinformationen für unterschiedliche Kompressionsstärken des erfindungsgemäßen Verfahrens zeigt.

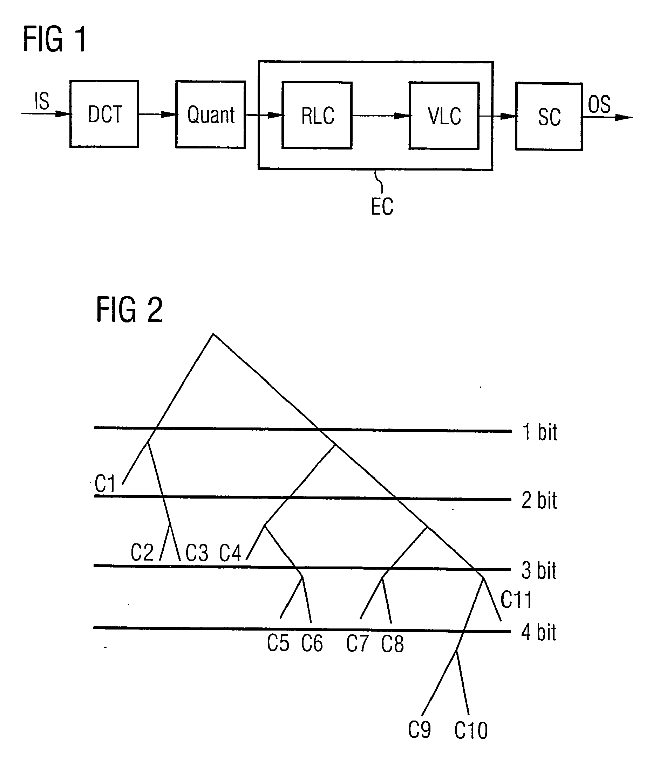

Fig. 1 zeigt ein Diagramm, welches die einzelnen Stufen des erfindungsgemäßen Verfahrens zur skalierbaren Codierung von Bildinformation darstellt. Zunächst wird ein Eingangssignal IS, welches die Bildinformation enthält, einer DCT-Codierung (Diskrete-Cosinus-Transformation) unterzogen. Hierzu wird das Bild in sogenannte DCT-Transformationsblöcke eingeteilt, auf welche die diskrete Cosinus-Transformation angewendet wird. Als Ergebnis der Transformation erhält man Spektralkoeffizienten, die in einem nächsten Schritt quantisiert werden. In diesem Quantisierungsschritt wird die Anzahl der Spektralkoeffizienten durch Einführung sogenannter Quantisierungsindizes reduziert. In einem nächsten Schritt wird die Entropiecodierung EC durchgeführt. Diese Codierung umfasst eine RLC-Codierung (Run Level Coding). Hierbei werden die Anzahl der aufeinander folgenden DCT-Koeffizienten mit dem Wert 0 vor einem DCT-Koeffizienten mit einem Wert ungleich 0 gezählt. Die Anzahl der Nullen wird als "Run" gespeichert und der Absolutwert des darauffolgenden DCT-Koeffizienten, der ungleich 0 ist, wird als "Level" gespeichert. Der RLC-Codierungsschritt ist optional und kann auch weggelassen werden. In einem nächsten Schritt wird eine VLC-Codierung (Variable Length Coding) durchgeführt. Hierbei werden Codewörter in Abhängigkeit von der Häufigkeit der auftretenden Symbole vergeben. Insbesondere werden für die häufiger auftretenden Symbole kürzere Codewörter verwendet als für seltenere Symbole. Hierdurch kann eine effektive Kompression erreicht werden. Als Ergebnis der VLC-Codierung erhält man VLC-Codewörter in der Form von unterschiedlich langen Codewörtern. Es sei angemerkt, dass bis zu diesem VLC-Codierschritt die verwendeten Techniken bereits aus dem Stand der Technik bekannt sind (siehe Druckschriften [1],[2] und [3]).

In einem nächsten Schritt wird nunmehr eine skalierbare Codierung SC in Abhängigkeit von der erwünschten Datenrate der zu übertragenden Bildinformation durchgeführt. Die skalierbare Codierung wird dabei auf die codierten VLC-Codewörter angewendet. Im Gegensatz zum Stand der Technik wird das Eingangssignal nur noch einer einzigen Entropiecodierung unterzogen und die Skalierung erfolgt nach der Entropiecodierung in einem zweiten Codierschritt SC. Nach der Durchführung dieser zweiten Codierung erhält man ein Ausgangssignal OS, welches komprimierte Codewörter umfasst.

In Fig. 2 ist beispielhaft ein VLC-Baum dargestellt, der nach der Durchführung der Entropiecodierung EC die VLC-Codewörter C1 bis C11 umfasst. Die einzelnen in dem Baum eingezeichneten Ebenen stellen die einzelnen Bits der VLC-Codewörter dar. Eine Verzweigung des Baumes nach links bedeutet, dass dem Bit der entsprechenden Ebene der Wert 0 zugewiesen wird. Eine Verzweigung nach rechts bedeutet die Zuweisung einer 1 für das entsprechende Bit. Bei dem in Fig. 2 gezeigten Beispiel gibt es insgesamt 11 unterschiedliche VLC-Codes, wobei das längste Codewort 5 Bits aufweist.

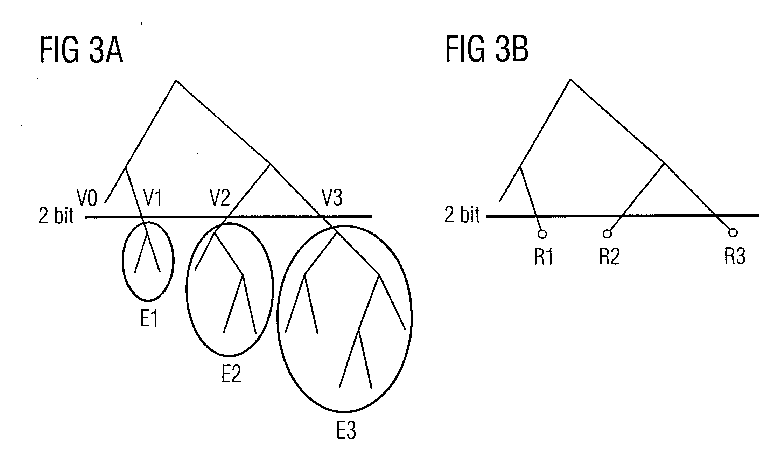

In Fig. 3A und 3B wird verdeutlicht, wie die VLC-Codewörter der Fig. 2 gemäß einer ersten Variante des erfindungsgemäßen Verfahrens komprimiert werden. Die Komprimierung erfolgt hierbei dadurch, dass alle VLC-Codewörter in der zweiten Bit-ebene abgeschnitten werden. Es ergeben sich somit neue Codewörter V0 bis V4, wobei die Codewörter V1, V2 und V3 verkürzt wurden. Jedem gekürzten Codewort ist dabei eine Anzahl von ungekürzten Codewörter zugeordnet. In dem vorliegenden Beispiel sind dem Codewort V1 zwei ungekürzte Codes, dem Codewort V2 drei ungekürzte Codewörter und dem Codewort V3 fünf ungekürzte Codewörter zugeordnet. Um eine Bildrekonstruktion mit ausreichender Bildqualität auf der Basis der verkürzten Codewörter zu gewährleisten, werden für jedes verkürzte Codewort V1, V2 und V3 jeweils die Erwartungswerte E1, E2 und E3 der decodierten Werte der entsprechenden ungekürzten Codewörter zugeordnet. Wie aus Fig.3B ersichtlich ist, entsprechen diese Erwartungswerte den Repräsentanten R1, R2 und R3. Die Zuordnung der gekürzten Codewörter zu den entsprechenden Repräsentanten sowie die Werte der Repräsentanten sind sowohl dem zur Codierung eingesetzten Encoder als auch dem zur Decodierung eingesetzten Decoder bekannt. Es ist zu beachten, dass bei der Verwendung einer RLC-Codierung im Entropiecodierschritt die Run-Level-Codewörter derart zu wählen sind, dass durch die Verkürzung der Codewörter nicht der Wert des Runs der zugeordneten ungekürzten Codewörter verändert wird, da sonst eine wesentliche Information über das Ursprungsbild verloren geht und somit nicht mehr die Wiederherstellung des Ursprungsbilds möglich ist.

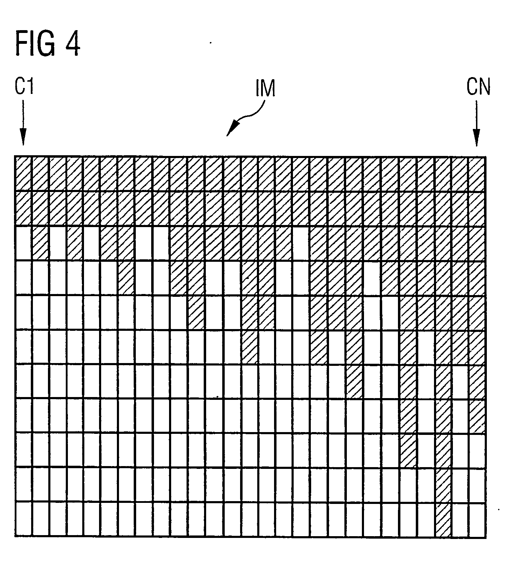

In Fig. 4 ist gezeigt, wie die einzelnen VLC-Codewörter zur Durchführung der ersten Variante des erfindungsgemäßen Verfahrens in einer Interleaver-Matrix IM gespeichert werden. Die Bits der ungekürzten Codeworte C1 bis CN werden spaltenweise in die Interleaver-Matrix IM geschrieben. Die Bits der Codewörter sind dabei in der Interleaver-Matrix grau dargestellt. Zur Erzeugung der verkürzten Codewörter werden die ungekürzten Codewörter zeilenweise ausgelesen, wobei nach einer gewissen Anzahl von Zeilen der Auslesevorgang abgebrochen wird. Zur Erzeugung von verkürzten Codewörter mit zwei Bits gemäß Fig. 3A und 3B wird der Auslesevorgang dann nach der zweiten Bitzeile abgebrochen. Es lassen sich somit auf einfache Art und Weise unterschiedlich lange verkürzte Codewörter erzeugen, wobei die Länge der verkürzten Codewörter von der erwünschten Datenrate für die Übertragung der Bildinformation abhängig gemacht wird. Es kann folglich problemlos eine Skalierung der Codierung vorgenommen werden.

Bei den in Fig.3A und 3B gezeigten verkürzten Codewörter wurden alle Codewörter in der gleichen Bitebene abgeschnitten. Es wurde somit nicht berücksichtigt, inwieweit ein einzelnes Codewort bei der Bildrekonstruktion von besonderer Relevanz ist. Die Relevanz eines einzelnen Codeworts kann sich insbesondere aus dem decodierten Wert ergeben, der dem Codewort zugeordnet ist. Ein anderes Kriterium ist die Position des Codeworts im codierten Signal. Diese Position kommt insbesondere bei quantisierten DCT-Blöcken in Betracht, bei denen die niederfrequenten Koeffizienten am Anfang eines Blocks von größerer Relevanz für die Bildrekonstruktion sind.

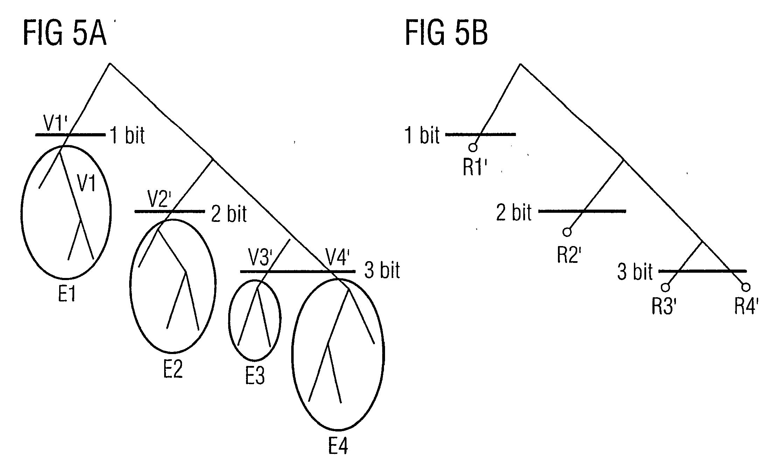

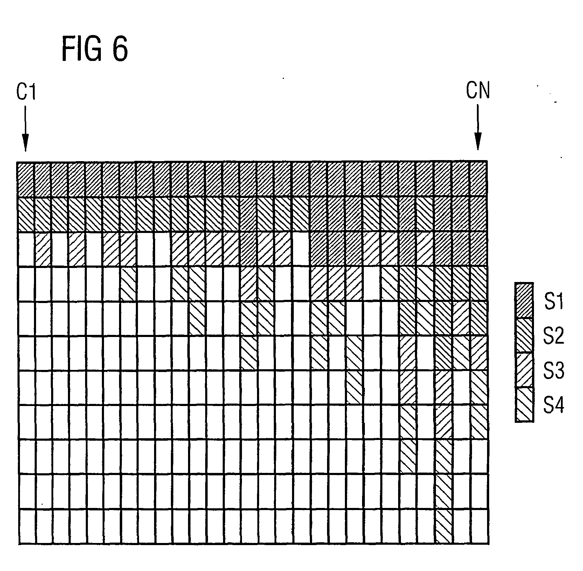

Fig. 5A und 5B zeigen ein Szenario gemäß einer zweiten Variante der Erfindung, wobei die Verkürzung von jedem Codewort zusätzlich von dem decodierten Wert des Codeworts und/oder von der Position des Codeworts im codierten Signal abhängig ist. Die Codewörter werden nunmehr nicht alle auf die gleiche Länge verkürzt, sondern es ergeben sich die Codewörter V1', V2', V3' und V4', wobei nur noch die Codewörter V3' und V4' die gleiche Länge aufweisen. In Analogie zu Fig. 3A und 3B werden die Erwartungswerte E1' bis E4' der zugeordneten ungekürzten Codewörter berechnet und als Repräsentanten R1' bis R4' den gekürzten Codewörter zugeordnet. Zur Durchführung des Verfahrens gemäß der zweiten Variante werden die ungekürzten Codewörter ebenfalls wieder spaltenweise in eine Interleaver-Matrix IM geschrieben, wie in Fig. 6 gezeigt ist. Die Bits dieser Codewörter sind in Fig. 6 grau gezeichnet, wobei es Bits in unterschiedlichen Graustufen gibt. Die Bits werden wie bei der erste Variante der Erfindung schichtweise ausgelesen, wobei jedoch zu beachten ist, dass die Anzahl der Bits pro Schicht von Codewort zu Codewort variieren kann. Dies ist in Fig.6 durch die Schichten S1 bis S4, die unterschiedliche Graustufen aufweisen, angedeutet. Ist die erwünschte Datenrate für die Übertragung der Bildinformation gering, wird stark komprimiert und es werden lediglich die Bits der Schicht S1 übertragen. Bei Erhöhung der Datenrate werden zusätzlich zu diesen Bits auch noch die Bits aus der Schicht S2 übertragen.

Bei weiterer Erhöhung der Datenrate kommen auch noch die Bits der Schicht S3 und S4 hinzu. Im Unterschied zu dem Verfahren gemäß der ersten Variante enthält jede Schicht nicht nur ein Bit, sondern die Anzahl der Bits pro Schicht variiert in Abhängigkeit vom Code.

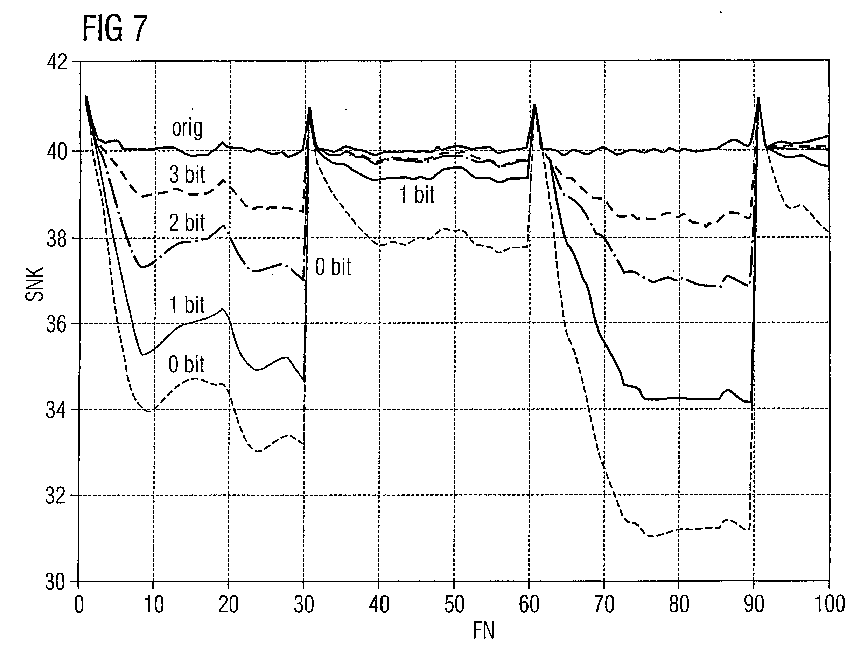

In Fig.7 ist ein Diagramm gezeigt, welches die Ergebnisse einer skalierbaren Bildcodierung gemäß der Erfindung zeigt. Es wurde hierbei ein Videobildsignal codiert. Auf der Abszisse ist die Frame-Nummer FN des Videobilds aufgetragen und auf der Ordinate das Signal-zu-Rausch-Verhältnis SNR für das Videobildsignal. Es sind dabei Verläufe für das Original- Videobild sowie für decodierte Videobilder gezeigt, deren Codewörter in unterschiedlichen Bitebenen verkürzt wurden. Beim Abschneiden in der "Null-Bit-Ebene", was einem einzelnen gekürzten VLC-Codewort entspricht, ergibt sich ein noch relativ schlechtes Signal-zu-Rausch-Verhältnis. Beim Abschneiden in höheren Bitebenen tritt jedoch eine deutliche Verbesserung des Signal-zu-Rausch-Verhältnisses ein. Es kann somit gemäß dem erfindungsgemäßen Verfahren eine effektive Kompression durch Verkürzung der VLC-Codewörter erreicht werden, wobei immer noch ein zufriedenstellendes Signal-zu-Rausch-Verhältnis gewährleistet ist.

### Literaturverzeichnis:

[1] Telecommunication Standardization Sector of ITU, ITU-T Draft H.263, 27.01.1998;
[2] Weiping Lee, "Overview of Fine Granularity Scalability in MPEG-4 Video Standard", IEEE Transactions on Circuits and Systems for Videotechnology, Vol. 11, No. 3, März 2001;
[3] WO 98/34196.

## Patentansprüche

1. Verfahren zur skalierbaren Codierung von Bildinformation, insbesondere Videobildinformation, bei dem:
- ein Eingangssignal (IS) mit der Bildinformation in einem ersten Codierschritt umfassend eine Entropiecodierung (EC) in ein erstes codiertes Signal mit einer Mehrzahl von Codewörter (C1, C2,..., CN) umgewandelt wird, wobei jedem Codewort (C1, C2,..., CN) ein decodierter Wert zugeordnet ist,
- das erste codierte Signal in einem zweiten Codierschritt (SC), bei dem das erste codierte Signal in Abhängigkeit von einer erwünschten Datenrate für die Übertragung der Bildinformation komprimiert wird, in ein zweites codiertes Signal umgewandelt wird,
- die Codewörter (C1, C2,..., CN) des ersten codierten Signals in dem zweiten Codierschritt verkürzt werden und jedem gekürzten Codewort (V1, V2, V3; V1', V2', V3', V4') ein Repräsentant (R1, R2, R3; R1', R2', R3', R4') zugeordnet wird,
- wenigstens einem gekürzten Codewort (V1, V2, V3; V1', V2', V3', V4') die durch die Verkürzung des Codeworts entfallenen ungekürzten Codewörter (C1,...,CN) zugeordnet werden und der Repräsentant (R1, R2, R3; R1', R2', R3', R4') des gekürzten Codeworts der Erwartungswert (E1, E2, E3; E1', E2', E3', E4') der decodierten Werte der dem gekürzten Codewort zugeordneten ungekürzten Codewörter (C1,...,CN) ist.

2. Verfahren nach Anspruch 1, bei dem die Länge, um die wenigstens ein ungekürztes Codewort (C1,...,CN) verkürzt wird, von dem decodierten Wert des ungekürzten Codeworts (C1,...,CN) abhängt.

3. Verfahren nach einem der vorhergehenden Ansprüche, bei dem die Länge, um die wenigstens ein ungekürztes Codewort (C1,...,CN) verkürzt wird, von der Position des ungekürzten Codeworts (C1,...,CN) im codierten Signal abhängt.

4. Verfahren nach einem der vorhergehenden Ansprüche, bei dem die Codewörter (C1,...,CN) des ersten codierten Signals in einer Matrix (IM) gespeichert werden, wobei die Matrix (IM) eine Mehrzahl von Schichten (S1, S2, S3, S4) umfasst und in jeder Schicht ein Abschnitt von wenigstens einem Codewort (C1,...,CN) gespeichert ist.

5. Verfahren nach Anspruch 4, wobei der Abschnitt ein einzelnes Bit oder ein Bitbündel ist.

6. Verfahren nach Anspruch 4 oder 5, bei dem die Codewörter (C1,...,CN) schichtweise ausgelesen werden, wobei die Anzahl der ausgelesenen Schichten (S1, S2, S3, S4) von der erwünschten Datenrate abhängt.

7. Verfahren nach einem der Ansprüche 4 bis 6, bei dem die jede Schicht mit einer Lauflängencodierung codiert wird.

8. Verfahren nach einem der vorhergehenden Ansprüche, bei dem der erste Codierschritt eine VLC-Codierung (Variable Length Coding) umfasst.

9. Verfahren nach einem der vorhergehenden Ansprüche, bei dem der erste Codierschritt eine RLC-Codierung (Run Level Coding) umfasst.

10. Verfahren nach einem der vorhergehenden Ansprüche, bei dem im ersten Codierschritt eine Transformationscodierung, insbesondere eine DCT-Codierung (Discrete Cosine Transform) durchgeführt wird.

11. Verfahren nach Anspruch 10, bei dem die Codewörter des ersten codierten Signals für Intra-Bilder in geringerem Maße komprimiert werden als für prädizierte P-Bilder.

12. Verfahren zur Decodierung eines codierten Signals mit Bildinformation, bei dem ein nach dem Verfahren der vorhergehenden Ansprüche erzeugtes zweites codiertes Signal decodiert wird, wobei jedem Codewort des zweiten codierten Signals ein Codewort des ersten codierten Signals zugeordnet wird, wobei wenigstens einem gekürzten Codewort (V1, V2, V3; V1', V2', V3', V4') die durch die Verkürzung des Codeworts entfallenen ungekürzten Codewörter (C1,...,CN) zugeordnet werden und ein Repräsentant (R1, R2, R3; R1', R2', R3', R4') des gekürzten Codeworts der Erwartungswert (E1, E2, E3; E1', E2', E3', E4') der decodierten Werte der dem gekürzten Codewort zugeordneten ungekürzten Codewörter (C1,...,CN) ist.

13. Codiereinheit zur skalierbaren Codierung von Bildinformation, mit der ein Verfahren nach einem der Ansprüche 1 bis 11 durchführbar ist, **gekennzeichnet durch**
- ein erstes Mittel zum Umwandeln eines Eingangssignals (IS) mit der Bildinformation in einem ersten Codierschritt umfassend eine Entropiecodierung (EC) in ein erstes codiertes Signal mit einer Mehrzahl von Codewörter (C1, C2,..., CN), wobei jedem Codewort (C1, C2,..., CN) ein decodierter Wert zugeordnet ist,
- ein zweites Mittel zum Umwandeln des ersten codierten Signals in einem zweiten Codierschritt (SC), bei dem das erste codierte Signal in Abhängigkeit von einer erwünschten Datenrate für die Übertragung der Bildinformation komprimiert wird, in ein zweites codiertes Signal,
- ein drittes Mittel zum Verkürzen der Codewörter (C1, C2,..., CN) des ersten codierten Signals in dem zweiten Codierschritt und zum Zuordnen eines Repräsentant (R1, R2, R3; R1', R2', R3', R4') jedem gekürzten Codewort (V1, V2, V3; V1', V2', V3', V4'),
- ein viertes Mittel zum Zuordnen wenigstens einem gekürzten Codewort (V1, V2, V3; V1', V2', V3', V4') die durch die Verkürzung des Codeworts entfallenen ungekürzten Codewörter (C1,...,CN), wobei der Repräsentant (R1, R2, R3; R1', R2', R3', R4') des gekürzten Code-worts der Erwartungswert (E1, E2, E3; E1', E2', E3', E4') der decodierten Werte der dem gekürzten Codewort zugeordneten ungekürzten Codewörter (C1,...,CN) ist.

14. Decodiereinheit zur Decodierung von Bildinformation, mit der ein Verfahren gemäß Anspruch 12 durchführbar ist, **gekennzeichnet durch**
- ein fünftes Mittel zum Decodieren eines nach einem Verfahren der vorhergehenden Ansprüche erzeugten zweiten codierten Signals, wobei jedem Codewort des zweiten codierten Signals ein Codewort des ersten codierten Signals zugeordnet wird,
- ein sechstes Mittel zum Zuordnen wenigstens einem gekürzten Codewort (V1, V2, V3; V1', V2', V3', V4') die durch die Verkürzung des Codeworts entfallenen ungekürzten Codewörter (C1,...,CN), wobei ein Repräsentant (R1, R2, R3; R1', R2', R3', R4') des gekürzten Codeworts der Erwartungswert (E1, E2, E3; E1', E2', E3', E4') der decodierten Werte der dem gekürzten Codewort zugeordneten ungekürzten Codewörter (C1,...,CN) ist.

15. Anordnung zur Codierung und Decodierung von Bildinformation, umfassend eine Codiereinheit nach Anspruch 13 und eine Decodiereinheit nach Anspruch 14.

## Claims

1. Method for the scalable coding of image information, especially video image information, wherein:
- in input signal (IS) containing the image information is converted in a first coding step comprising an entropy coding (EC) to a first coded signal with a number of code words (C1, C2, ... CN), with a decoded value being assigned to each code word (C1, C2, ... CN),
- the first coded signal is converted to a second coded signal in a second coding step (SC), wherein the first coded signal is compressed as a function of a desired data rate for transmission of the image information,
- the code words (C1, C2, ... CN) of the first coded signal are shortened in the second coding step and a representative (R1, R2, R3; R1', R2', R3', R4') is assigned to each shortened code word (V1, V2, V3; V1', V2', V3', V4'),
- the unshortened code words (C1, ... CN) no longer necessary due to the shortening of the code word are assigned to at least one shortened code word (V1, V2, V3; V1', V2', V3', V4'), and the representative (R1, R2, R3; R1', R2', R3', R4') of the shortened code word is the expectancy value (E1, E2, E3; E1', E2', E3', E4') of the decoded values of the unshortened code words (C1, ... CN) assigned to the shortened code word.

2. Method according to claim 1, wherein the length, by which at least one unshortened code word (C1, ... CN) is shortened, is a function of the decoded value of the unshortened code word (C1, ... CN).

3. Method according to one of the preceding claims, wherein the length, by which at least one unshortened code word (C1, ... CN) is shortened, is a function of the position of the unshortened code word (C1, ... CN) in the coded signal.

4. Method according to one of the preceding claims, wherein the code words (C1, ... CN) of the first coded signal are stored in a matrix (IM), with the matrix (IM) having a number of layers (S1, S2, S3, S4) and a section of at least one code word (C1, ..., CN) being stored in each layer.

5. Method according to claim 4, wherein the section is an individual bit or a bundle of bit.

6. Method according to claim 4 or 5, wherein the code words (C1, ..., CN) are read out layer by layer, with the number of layers (S1, S2, S3, S4) read out being a function of the desired data rate.

7. Method according to one of claims 4 to 6, wherein each layer is coded with a run-length coding.

8. Method according to one of the preceding claims, wherein the first coding step comprises a VLC coding (Variable Length Coding).

9. Method according to one of the preceding claims, wherein the first coding step comprises an RLC coding (Run Level Coding).

10. Method according to one of the preceding claims, wherein a transformation coding, especially a DCT coding (Discrete Cosine Transform) is carried out in the first coding step.

11. Method according to claim 10, wherein the code words of the first coded signal for intra images are compressed to a lesser degree than for predicted P images.

12. Method for decoding a coded signal containing image information, wherein a second coded signal generated according to the method in the preceding claims is decoded, with a code word of the first coded signal being assigned to each code word of the second coded signal, with the unshortened code words (C1, ... CN) no longer necessary due to the shortening of the code word being assigned to at least one shortened code word (V1, V2, V3; V1', V2', V3', V4'), and a representative (R1, R2, R3; R1' , R2', R3', R4') of the shortened code word being the expectancy value (E1, E2, E3; E1', E2', E3', E4') of the decoded values of the unshortened code words (C1, ... CN) assigned to the shortened code word.

13. Coding unit for the scalable coding of image information, with which a method according to one of claims 1 to 11 can be implemented, **characterised by**
- a first means for converting an input signal (IS) containing the image information in a first coding step comprising an entropy coding (EC) to a first coded signal with a number of code words (C1, C2, ... CN), with a decoded value being assigned to each code word (C1, C2, ... CN),
- a second means for converting the first coded signal to a second coded signal in a second coding step (SC), wherein the first coded signal is compressed as a function of a desired data rate for transmission of the image information,
- a third means for shortening the code words (C1, C2, ... CN) of the first coded signal in the second coding step and for assigning a representative (R1, R2, R3; R1', R2', R3', R4') to each shortened code word (V1, V2, V3; V1', V2', V3', V4'),
- a fourth means for assigning the unshortened code words (C1, ... CN) no longer necessary due to the shortening of the code word to at least one shortened code word (V1, V2, V3; V1', V2', V3', V4'), with the representative (R1, R2, R3; R1', R2', R3', R4') of the shortened code word being the expectancy value (E1, E2, E3; E1', E2', E3', E4') of the decoded values of the unshortened code words (C1, ... CN) assigned to the shortened code word.

14. Decoding unit for decoding image information, with which a method according to claim 12 can be implemented,
**characterised by**
- a fifth means for decoding a second coded signal generated according to a method in the preceding claims, with a code word of the first coded signal being assigned to each code word of the second coded signal,
- a sixth means for assigning the unshortened code words (C1, ... CN) no longer necessary due to the shortening of the code word to at least one shortened code word (V1, V2, V3; V1', V2', V3', V4'), with a representative (R1, R2, R3; R1', R2', R3', R4') of the shortened code word being the expectancy value (E1, E2, E3; E1', E2', E3', E4') of the decoded values of the unshortened code words (C1, ... CN) assigned to the shortened code word.

15. Arrangement for coding and decoding image information, comprising a coding unit according to claim 13 and a decoding unit according to claim 14.

## Revendications

1. Procédé pour le codage échelonnable d'informations image, notamment d'informations image vidéo, dans lequel :
- un signal d'entrée (IS) est converti avec l'information image, dans une première étape de codage comprenant un codage d'entropie (EC), en un premier signal codé au moyen d'une pluralité de mots de code (C1, C2, ..., CN), une valeur décodée étant affectée à chaque mot de code (C1, C2, ..., CN),
- le premier signal codé est converti en un deuxième signal codé, dans une deuxième étape de codage (SC), pendant laquelle le premier signal codé est compressé en fonction d'un débit de données désiré pour la transmission de l'information image,
- les mots de code (C1, C2, ..., CN) du premier signal codé sont raccourcis dans la deuxième étape de codage et dans lequel un représentant (R1, R2, R3 ; R1', R2', R3', R4') est affecté à chaque mot de code raccourci (V1, V2, V3 ; V1', V2', V3', V4'),
- les mots de code non raccourcis (C1, ..., CN) supprimés en raison du raccourcissement du mot de code sont affectés à au moins un mot de code raccourci (V1, V2, V3 ; V1', V2', V3', V4') et dans lequel le représentant (R1, R2, R3 ; R1', R2', R3', R4') du mot de code raccourci est la valeur attendue (E1, E2, E3 ; E1', E2', E3', E4') des valeurs décodées des mots de code (C1, ... ;CN) non raccourcis affectés au mode de code raccourci.

2. Procédé selon la revendication 1, dans lequel la longueur, de laquelle au moins un mot de code non raccourci (C1, ..., CN) est raccourci, dépend de la valeur décodée du mot de code non raccourci (C1, ..., CN).

3. Procédé selon l'une quelconque des revendications précédentes, dans lequel la longueur, de laquelle au moins un mot de code non raccourci (C1, ..., CN) est raccourci, dépend de la position du mot de code non raccourci (C1, ..., CN) dans le signal codé.

4. Procédé selon l'une quelconque des revendications précédentes, dans lequel les mots de code (C1, ..., CN) du premier signal codé sont mémorisés dans une matrice (IM), la matrice (IM) comprenant une pluralité de couches (S1, S2, S3, S4) et une section d'au moins un mode de code (C1, ..., CN) étant mémorisée dans chaque couche.

5. Procédé selon la revendication 4, la section étant un bit unique ou une rafale de bits.

6. Procédé selon la revendication 4 ou 5, dans lequel les mots de code (C1, ..., CN) sont lus couche par couche, le nombre de couches lues (S1, S2, S3, S4) dépendant du débit de données désiré.

7. Procédé selon l'une quelconque des revendications 4 à 6, dans lequel chaque couche est codée au moyen d'un codage par longueur de plage.

8. Procédé selon l'une quelconque des revendications précédentes, dans lequel la première étape de codage comprend un codage VLC (Variable Length Coding).

9. Procédé selon l'une quelconque des revendications précédentes, dans lequel la première étape de codage comprend un codage RLC (Run Level Coding).

10. Procédé selon l'une quelconque des revendications précédentes, dans lequel un codage de transformation, notamment un codage DCT (Discrete Cosine Transform) est réalisé dans la première étape de codage.

11. Procédé selon la revendication 10, dans lequel les mots de code du premier signal codé sont compressés pour des images intra de manière moindre que pour des images P.

12. Procédé de décodage d'un signal codé avec une information image, dans lequel un deuxième signal codé, généré selon le procédé des revendications précédentes, est décodé, un mot de code du premier signal codé étant affecté à chaque mot de code du deuxième signal codé, les mots de code non raccourcis (C1, ..., CN) supprimés en raison du raccourcissement du mot de code étant affectés à au moins un mot de code raccourci (V1, V2, V3 ; V1', V2', V3', V4') et un représentant (R1, R2, R3 ; R1', R2', R3', R4') du mot de code raccourci étant la valeur attendue (E1, E2, E3 ; E1', E2', E3', E4') des valeurs décodés des mots de code non raccourcis (C1, ..., CN) affectés au mot de code raccourci.

13. Unité de codage pour le codage échelonnable d'informations image, au moyen de laquelle un procédé selon l'une quelconque des revendications 1 à 11 est réalisable, **caractérisée par**
- un premier moyen destiné à convertir un signal d'entrée (IS) avec l'information image, dans une première étape de codage comprenant un codage d'entropie (EC), en un premier signal codé au moyen d'une pluralité de mots de code (C1, C2, ..., CN), une valeur décodée étant affectée à chaque mot de code (C1, C2, ..., CN),
- un deuxième moyen destiné à convertir le premier signal codé, dans une deuxième étape de codage (SC), pendant laquelle le premier signal codé est compressé en fonction d'un débit de données désiré pour la transmission de l'information image, en un deuxième signal codé,
- un troisième moyen destiné à raccourcir les mots de code (C1, C2, ..., CN) du premier signal codé dans la deuxième étape et destiné à affecter un représentant (R1, R2, R3 ; R1', R2', R3', R4') à chaque mot de code raccourci (V1, V2, V3 ; V1', V2', V3', V4'),
- un quatrième moyen destiné à affecter les mots de code non raccourcis (C1, ..., CN) supprimés en raison du raccourcissement du mot de code à au moins un mot de code raccourci (V1, V2, V3 ; V1', V2', V3', V4'), le représentant (R1, R2, R3 ; R1', R2', R3', R4') du mot de code raccourci étant la valeur attendue (E1, E2, E3 ; E1' , E2', E3', E4') des valeurs décodées des mots de code non raccourcis (C1, ..., CN) affectés au mot de code raccourci.

14. Unité de décodage pour le décodage d'informations image, au moyen de laquelle un procédé selon la revendication 12 est réalisable, **caractérisée par**
- un cinquième moyen destiné à décoder un deuxième signal codé généré selon un procédé des revendications précédentes, un mot de code du premier signal codé étant affecté à chaque mot de code du deuxième signal codé,
- un sixième moyen destiné à affecter les mots de code non raccourcis (C1, ..., CN) supprimés en raison du raccourcissement du mot de code à au moins un mot de code raccourci (V1, V2, V3 ; V1', V2', V3', V4'), un représentant (R1, R2, R3 ; R1', R2', R3', R4') du mot de code raccourci étant la valeur attendue (E1, E2, E3 ; E1' , E2', E3', E4') des valeurs décodées des mots de code non raccourcis (C1, ..., CN) affectés au mot de code raccourci.

15. Dispositif de codage et décodage d'informations image, comprenant une unité de codage selon la revendication 13 et une unité de décodage selon la revendication 14.
